# EUROPEAN PATENT SPECIFICATION

(11) **EP 1 918 963 B1**
(45) Date of publication and mention of the grant of the patent: **23.04.2014**
(21) Application number: 07119687.7
(22) Date of filing: 31.10.2007
(51) Int. Cl.: H01J 37/08, H01J 37/305, H01J 37/317

(54) **Charged particle beam processing using a cluster source**
Ladungsträgerteilchenstrahlbearbeitung mittels einer Cluster-Quelle
Traitement à faisceau de particule chargé utilisant une source de agrégat

(30) Priority: 31.10.2006 US 590570
(43) Date of publication of application: 07.05.2008
(73) Proprietor: FEI COMPANY, Hillsboro, Oregon 97124-5793 (US)
(72) Inventor: Chandler, Clive, Portland, OR 97212 (US); Smith, Noel, Lake Oswego, OR 97035 (US)
(74) Representative: Bakker, Hendrik

(56) References cited:
- EP-A- 1 679 505
- WO-A-01/40532
- WO-A-97/38355
- WO-A-98/47172
- WO-A1-00/26431
- WO-A2-01/40532
- GB-A- 2 386 747
- US-A- 5 083 033
- US-A- 5 683 547
- US-A- 5 814 194

## Description

### Technical field of the invention.

The invention relates to a method for processing a work piece with a beam of charged particles, the method comprising:
- positioning the work piece in a vacuum chamber, and
- irradiating the work piece surface with a focused beam of charged particles to process the work piece.
   The invention further relates to an apparatus equipped to perform the method.

### Background of the invention.

Such a method is known to be performed in a Focused Ion Beam machines (FIB).
Charged-particle beams, such as ion beams and electron beams, are used for processing work pieces in nanotechnology because charged-particle beams can form very small spots. For example, focused ion beam systems are able to image, mill, deposit, and analyze with sub-micron precision. Focused ion beam systems are commercially available, for example, from FEI Company, Hillsboro, Oregon, the assignee of the present application. The ions can be used to sputter, that is, physically eject, material from a work piece to produce features, such as trenches, in the work piece. An ion beam can also be used to activate an etchant gas to enhance sputtering, or to decompose a precursor gas to deposit material near the beam impact point. An ion beam can also be used to form an image of the work piece, by collecting secondary particles ejected by the impact of the ion beam. The number of secondary particles ejected from each point on the surface is used to determine the brightness of the image at a corresponding point on the image.

Focused ion beams are often used in the semiconductor industry. In one application, for example, a focused ion beam is used to cut a small trench into an integrated circuit to expose a cross section of a vertical structure for observation or measurement using an ion beam or an electron beam.

Another use of a FIB is in the preparation of a work piece, also known as sample, for a Transmission Electron Microscope (TEM) or a Scanning Transmission Electron Microscope (STEM).
In a TEM a broad electron beam impacts the sample and electrons that are transmitted through the sample are focused to form an image of the sample.
In a STEM a primary electron beam is focused to a fine spot, and the spot is scanned across the sample surface.
In a TEM or a STEM electrons that are transmitted through the sample are collected by an electron detector on the far side of the sample. A sample for a TEM or a STEM must be sufficiently thin to allow many of the electrons in the primary beam to travel though the sample and exit on the opposite site. Samples are typically thinned to a thickness of less than 100 nm. One method of preparing samples includes using a focused ion beam to cut a thin sample from a work piece, and then using the ion beam to thin the sample.

A disadvantage of the known method is that, when a charged-particle beam impacts a surface, there is the potential for damage or alteration of the surface. The alteration can e.g. take the form of implantation of the work piece with ions forming the charged-particle beam, dimensional changes, or -in the case of crystalline work piece- phase changes.
Focused ion beam systems typically use gallium ions from liquid metal gallium ion source. Gallium ions are relatively heavy, and a gallium ion accelerated through a typical 30,000 volts will inevitably alter the work piece surface. Plasma ion systems, such as the one described in WO20050081940 of Keller et al. for a "Magnetically Enhanced, Inductively Coupled, Plasma Source for a Focused Ion Beam System", can use lighter ions, which cause less damage, but the ions will still typically alter the work piece surface.
Electrons, while much lighter than ions, can also alter a work surface. When a user desires to measure a work piece with an accuracy of nanometers, changes in the work piece caused by the impact of charged particles can be significant, especially in softer materials, such as photoresist and low-k and ultra-low-k dielectric materials, such as polyphenylene materials.

WO 00/26431 describes the use of a cluster ion bean used to form a thin nitride layer on a wafer. A chemical reaction involving the nitrogen compound in the beam forms and the substrate surface forms the nitride layer. For deposition of gallium-containing films, gallium vapor from a sublimation source fall on the substrate coincident with the nitrogen-cluster ion beam.

When a user desires to use an ion beam to extract a sample for imaging it with a TEM, as described for example, in U.S. Pat. No. 5,270,552 to Ohnishi, et al. "Method for Separating Specimen and Method for Analyzing the Specimen Separated by the Specimen Separating Method," the user typically scans the focused

When a user desires to use an ion beam to extract a sample for imaging it with a TEM, as described for example, in U.S. Pat. No. 5,270,552 to Ohnishi, et al. "Method for Separating Specimen and Method for Analyzing the Specimen Separated by the Specimen Separating Method," the user typically scans the focused ion beam in an imaging mode to locate the region of interest. The scanning causes damage to the surface. When the region of interest is located and the beam begins to mill a trench, there is additional damage to the work piece because the edges of the beam are not perfectly sharp. That is, the beam is typically Gaussian shaped, and the ions in the tail of the Gaussian distribution will damage the work piece at the edge of the trench. Damage has been found not just on fragile materials, but also on relatively hard materials.

To protect the work piece surface, it is common to apply a protective layer before charged-particle-beam processing. One method of applying a protective layer is charged-particle-beam deposition, that is, using a charged-particle beam to provide energy to decompose a gas to deposit a material on the surface. The protective layer shields the area around the cut and preserves the characteristics of the features that are to be imaged and measured. Commonly used deposition gases include precursor compounds that decompose to deposit tungsten, platinum, gold, and carbon. For example, tungsten hexacarbonyl can be used to deposit tungsten, methylcyclopentadienyl trimethyl platinum can be used to deposit platinum, and styrene can be used to deposit carbon. Precursor gases to deposit many different materials are known in the art. The preferred material to be deposited as a protective layer depends on the application, including the composition of the underlying target surface, and the interaction between the protective layer material and the target surface.

Charged-particle-beam-assisted deposition can locally apply a layer at the precise location where the layer is needed.
A disadvantage of this method is that it is relatively slow and, in some processes, up to sixty percent of the total processing time is consumed in deposition of the protective layer.
Another disadvantage is that, when an ion beam is initially scanned onto the target surface to deposit material, the beam sputters material away from the surface for an initial period of time until a sufficient amount of deposition material accumulates to shield the surface from the ion beam. Even though that period of time may be small, it can be large enough to allow a significant amount of material to be removed, which causes the accuracy of the cross-sectional analysis to be compromised.
Still another disadvantage is that implantation of the ions of the charged-particle beam into the work piece may occur.

Electron and laser beams can be used to generate secondary electrons to decompose a precursor gas to deposit a protective layer.
A disadvantage of this method is that those beams may also damage the underlying surface-especially when they are at sufficient energy and/or current density levels for achieving favorable processing time. It is generally not practical to use such beams because deposition will be too slow if the beams are sufficiently "weak" to avoid harm to the underlying surface.

Physical vapor deposition ("PVD") sputter methods could be used to deposit protective layers in some applications, but they normally cannot be utilized for production control applications in wafer fabrication facilities because such methods cannot be used to locally apply a deposition layer onto a targeted part of the wafer surface. U.S. Pat. App. No. 60/773,396, which is assigned to the assignees of the present invention, describes a method of PVD that can provide a localized layer. A charged-particle beam is used to sputter material from a target onto the surface. The charged-particle beam is not directed to the surface itself and damage is avoided.
A disadvantage of this method is that it is time consuming.

Another method of applying a protective coating is described is U.S. Pat. No. 6,926,935 to Arjavec et al. for "Proximity Deposition." In this method, the charged-particle beam is not directed at the area of interest, but to a region outside the area of interest. Secondary electrons decompose the precursor gas over the area of interest to provide a protective layer. As the protective layer is being created around the edge of the region of interest, the charged-particle beam can be moved inward.
A disadvantage of this method is that it is time consuming.

Colloidal silver applied with a brush has long been used to produce a conductive protective layer in scanning electron microscopy.
A disadvantage of this method is that the silver particles used are relatively large. Another disadvantage is that using a brush to apply the layer can damage the substrate and cannot provide a localized layer.

Another method of applying a protective coating is to use a felt tip pen, such as a Sharpie brand pen from the Sanford division of Rubbermaid Corporation. The ink from a Sharpie pen is suitable for use in a vacuum chamber, because it dries thoroughly, and there is little outgassing in the vacuum chamber.
A disadvantage of this method is that touching the pen to the region of interest would alter the surface, so the ink is applied near the region of interest, and the ink then wicks onto the region of interest. Compounds in the ink protect some surfaces.
Another disadvantage of this method is that the area affected by the felt tip is very large compared to the sub-micron features of modern integrated circuits, and the positioning accuracy of the ink is insufficient.

### Aim of the invention.

The industry needs a method of irradiating a work piece with charged particles without damaging a work piece surface.

### Summary of the invention.

To that end the method according to the invention is characterized in that a focused beam of charged clusters of atoms or molecules is directed to the work piece such that said focused beam of cluster initiates a chemical reaction in which a gas, which is simultaneously directed to the work piece, decomposes to deposit a material onto the work piece or the gas is activated to etch the work piece to remove a material from the work piece.

A cluster of atoms or molecules accelerated by an electric field (caused by a potential difference of e.g. n kV) has, when it impinges on a work piece, the same total energy (e.g. n keV) as a single ion or ionized molecule with the same charge. However, the bond between the atoms or molecules forming the cluster is rather small, and at impact the cluster can best be described by a cluster of particles (atoms or molecules) with each of the particles having only a part of the original energy of e.g. n keV. Due to this low energy per particle the damage to the work piece is much lower than caused by ions having an energy of e.g. n keV.

As a result of the reduced energy per particle the implantation depth decreases, the phase change in crystalline material is limited to a much smaller depth, and dimensional changes are also much less.
Using clusters therefore typically reduces damage to the work piece compared to using individual ions.

It is noted that a similar reduction in damage could be achieved by using ions with a much reduced energy. However, as known to the person skilled in the art, such low energy makes it also much more difficult to e.g. focus the ions on the work piece, resulting in a much larger charged particle beam diameter on the work piece and thus a less localized effect. This implies that the current density is much lower. Also, the amount of particles per unit of charge for an ion is much lower than when using a cluster, further reducing the number of particles per m², and thereby resulting in a much reduced etching or deposition speed.

It is further noted that applying a protective layer of fullerene molecules for computer disk drive components is described, for example, in U.S. Pat. No. 6,743,481 to Hoehn et al. for "Process for Production of Ultrathin Protective Overcoats" and U.S. Pat. Pub. No. 20020031615 of Dykes et al. for "Process for Production of Ultrathin Protective Overcoats." Fullerenes are ejected from a source by the impact of an ion beam or an electron beam, and some of the fullerenes are ejected in the direction of the target and coat it.
In this method the cluster of carbon atom in the form of fullerenes are not ionised and the work piece to be covered with an overcoat is not irradiated with a charged particle beam to process the work piece.

In an embodiment of the method according to the invention the beam of charged clusters comprises clusters comprising carbon, gold, bismuth or xenon.

Each of these species has its own applications. Xenon, being a noble gas, does not bond chemically to the work piece, and is well-known as a sputtering gas. E.g. carbon can form protective layers of a desired kind.

In a further embodiment of the method according to the invention the beam of charged clusters comprises clusters comprising C₆₀, C₇₀, C₈₀, C₈₄, Au₃, Bi₃ or Xe₄₀.

In a still further embodiment of the method according to the invention the charged clusters comprise fullerenes.

Fullerenes are clusters composed (almost) entirely of carbon, in the form of a hollow sphere, ellipsoid, or tube. Also fullerenes in which an atom of another species, such as a rare earth atom, is enclosed in the hollow sphere, ellipsoid or tube, are known.

In another embodiment of the method according to the invention a gas is directed to the work piece, the gas activating in the presence of the beam of charged clusters to deposit a material onto the work piece or to remove a material from the work piece.

The use of such a gas is known in a FIB and is used to deposit material on a work piece or to etch a work piece, where the gas is activated by the ions. Experiments show that also charged clusters are capable of activating the commonly used gases.

In a further embodiment of the method according to the invention the gas reacts in the presence of the focused beam of charged clusters to etch the work piece.

This embodiment describes the use of an etch-enhancing gas, and the beam of clusters provides energy to initiate a chemical reaction to etch the work piece with reduced damage outside of the etched area.

In a yet further embodiment of the method according to the invention the gas comprises XeF₂, F₂, Cl₂ Br₂, I₂, a fluorocarbon, trifluoro acetamide, trifluoroacetic acid, trichloroacetic acid, water, ammonia, or oxygen.

The mentioned gases are known as etchant gases and are commonly used in FIB's with gas injection systems.

In another embodiment of the method according to the invention the gas comprises a precursor gas comprising a silane compound or an organometallic compound, the precursor gas decomposing in the presence of the beam of charged clusters, the decomposed gas thereby forming a deposited layer on the work piece.

The use of such gases is known in FIB's equipped with a gas injection system for depositing a layer.

In a further embodiment of the method according to the invention the gas comprises tetramethylorthosilane (TMOS), tetraethylorthosilane (TEOS), tetrabutoxysilane (Si(OC₄ H₉)), dimethyl acetylacetonate gold, tungsten hexacarbonyl (W(CO)₆), or methylcyclopentadienyl trimethyl platinum (C₉H₁₆Pt).

The mentioned gases are known as gases causing a deposition when irradiated by ions and are commonly used in FIB's with gas injection systems.

In another embodiment of the method according to the invention the work piece is irradiated with a beam of charged clusters so as to form a deposited layer, and the thus formed deposited layer is irradiated with a further beam of charged particles.

In this embodiment the cluster beam is used to e.g. provide a protective layer on the work piece without causing damage, and another charged particle beam, such as a conventional ion beam or an electron beam, is used to process the work piece.
It is noted that the irradiation by the further beam can take place after the protective layer is made, but that irradiation with the further beam can also take place while the protective layer is added.

In a further embodiment of the method according to the invention the further beam of charged particles is a focused beam of ions or electrons.

In another embodiment of the method according to the invention directing a beam of charged clusters to the work piece includes directing a beam of charged clusters from a plasma ion source to the work piece.

Plasma ion sources are known to produce clusters.

In a further embodiment of the method according to the invention the plasma ion source is an inductively coupled plasma ion source.

This preferred implementation of the invention uses a plasma source as described in e.g. U.S. Pat. App. Pub. No. 2005/0183667 for a "Magnetically Enhanced, Inductively Coupled Plasma Source for a Focused Ion Beam System". Such an ion source provides a beam having very low chromatic aberration and can be focused to a relatively small spot at a relatively high beam current, making it suitable for precise micromachining and deposition. Such a source can provide beams of clusters, as well as beams of individual atoms and molecules for charged particle beam processing. For example, a cluster beam can be used to deposit a protective layer, and then an argon beam can be used with xenon difluoride to micromachine a feature in the work piece.

In another embodiment of the method according to the invention directing a beam of charged clusters to the work piece includes directing a beam of charged clusters from an evaporative cluster source to the work piece.

In yet another embodiment of the method according to the invention the deposited layer comprises the material of which the charged clusters are formed.

When depositing material also the material of the clusters themselves can be used as building material. This can contribute significantly to the deposition speed.
It is noted that depositing material from the clusters can be done in conjunction with depositing material from a gas, but that it can also be the sole building material of the deposition.

In a further embodiment of the method according to the invention the deposited layer is formed in the absence of a gas.

In another embodiment of the method according to the invention the clusters forming the beam of charged clusters have a charge-per-atom ratio of less than 0.1.

For a typical ion, such as Ga⁺, the charge-per-atom ratio is one. For multiple charged ions, such as Ga²⁺, this ratio is even larger than one. The charge-per-atom ratio of a cluster can be much lower than one. By using clusters with a charge-per-atom ratio of less than 0.1 the damage caused by the impact of such clusters is limited, as explained before.

In a further embodiment of the method according to the invention the charge-per atom ratio is less than 0.02.

In this embodiment even less damage is caused. Such charge-per-atom ratios can be achieved when using larger clusters, with in excess of 50 atoms. This includes some of the more commonly used fullerenes.

In an aspect of the invention a charged particle apparatus is provided according to claim 19.

This aspect describes an apparatus equipped to perform the methods described before. The charged clusters can be the only charge particle beam, but another charged particle beam may be used as well.

In an embodiment of the apparatus according to the invention the beam of charged clusters is produced by the charged particle source and the apparatus further comprises a gas injection system for directing a gas to the work piece position.

This embodiment describes an apparatus in which the beam of charged clusters is focused on the work piece, and a jet of gas is directed to the work piece. Hereby gases from the jet can be activated locally, as a result of which finely featured processing (etching or deposition) can take place.

In another embodiment of the apparatus according to the invention the charged particle source does not produce charged clusters.

Here the apparatus is equipped with a further charged particle beam, e.g. for processing the work piece.

In yet another embodiment of the apparatus according to the invention the charged clusters are produced by a cluster ion source, the cluster ion source including a plasma ion source.

In a further embodiment of the apparatus according to the invention the plasma ion source is an inductively coupled plasma ion source.

In another embodiment of the apparatus according to the invention the charged clusters are produced by a cluster ion source, the cluster ion source including an evaporative cluster ion source.

In still another embodiment of the apparatus according to the invention the charged clusters are produced by a cluster ion source, the cluster ion source equipped to produce clusters comprising fullerenes, bismuth, gold, or xenon.

### Brief Description of the Drawings

For a more through understanding of the present invention, and advantages thereof, reference is now made to the following descriptions taken in conjunction with the accompanying drawings, in which:
FIG. 1 shows a preferred embodiment of the invention system including a plasma source that is capable of generating charged clusters of atoms and directing the clusters toward a sample,
FIG. 2 shows a preferred method in accordance with the invention,
FIG. 3 shows a preferred plasma cluster source, and
FIG. 4 shows an alternative cluster source.

### Detailed Description of Preferred Embodiments

The following is a detailed description of example embodiments of the invention depicted in the accompanying drawings. The example embodiments are in such detail as to clearly communicate the invention. However, the amount of detail offered is not intended to limit the anticipated variations of embodiments; but, on the contrary, the intention is to cover all modifications, equivalents, and alternatives falling within the scope of the present invention as defined by the appended claims. The detailed descriptions below are designed to make such embodiments obvious to a person of ordinary skill in the art.

In some embodiments of the invention, a cluster beam provides energy to decompose a precursor gas to deposit a layer, while minimizing damage to the work piece surface. The cluster beam can also be used to etch the work piece surface, optionally with an etch-enhancing gas. In other embodiments, a cluster beam directly deposits a protective layer for charged particle beam processing, preferably the protective layer deposition and the charged particle beam processing occurring in the same vacuum chamber.

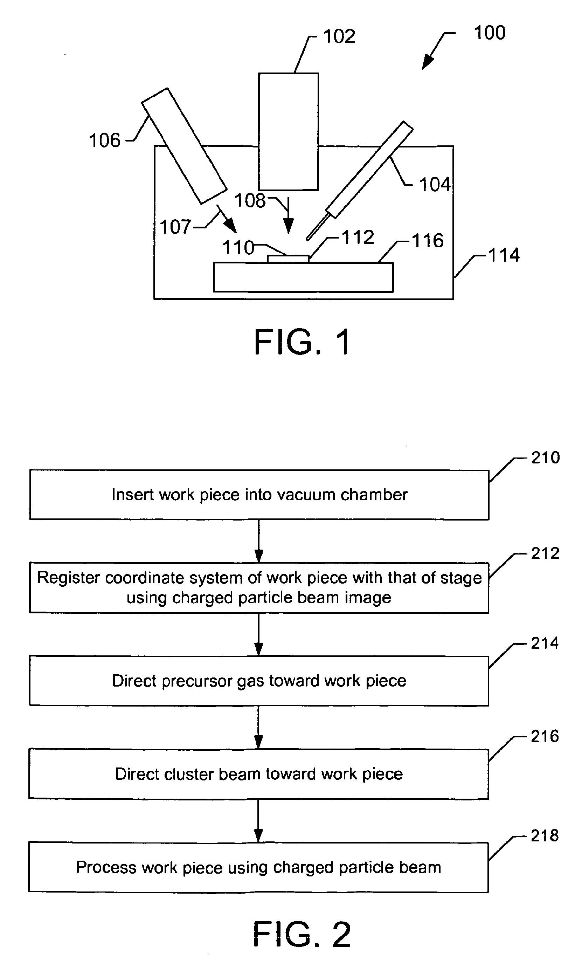

FIG. 1 shows a simplified illustration of an embodiment of the invention that comprises a charged particle beam system 100 including a cluster ion source 102, a gas injection system 104, and preferably an electron beam column 106, producing another charged particle beam 107. A gas injection system is described, for example, in U.S. Pat. No. 5,851,413 to Casella et al. for "Gas Delivery Systems for Particle Beam Processing," assigned to the assignee of the present invention. Another gas delivery system is described in U.S. Pat. No. 5,435,850 to Rasmussen for a "Gas Injection System," also assigned to the assignee of the present invention. Cluster source 102 provides a beam 108 of clusters of atoms or molecules directed toward a region of interest 110 on a work piece 112, which is positioned within a vacuum chamber 114 on a stage 116, preferably capable of moving in at least two directions. It is noted that the column 106 may also be a focused ion beam column, generating a focused beam of ions 107 for e.g. etching or milling.

FIG. 2 shows a preferred process in accordance with the invention. In step 210, a work piece is inserted into vacuum chamber 114. In step 212, a portion of the work piece 112 is imaged using the electron beam column 106 to locate markings on the work piece surface to register the coordinate system of the stage 116 with the coordinate system of the work piece 112 so that the stage 116 can be moved to position region of interest 110 within an area toward to which the cluster beam can be directed. In step 214, a jet of a precursor gas is directed toward the work piece 112 in the vicinity of the region of interest 110. Many deposition precursor gases are known, including tetramethylorthosilane (TMOS), tetraethylorthosilane (TEOS), tetrabutoxysilane Si(OC₄ H₉), dimethyl acetylacetonate gold, organometallic compounds, such as tungsten hexacarbonyl (W(CO)₆), and methylcyclopentadienyl trimethyl platinum (C₉H₁₆Pt).

In step 216, the beam of clusters is directed to the work piece surface to provide energy to decompose the precursor gas and deposit a protective layer. Clusters of different types of atoms or molecules can be used with the invention. The term "cluster" includes groups of multiple molecules or atoms. For example carbon in the form of fullerenes (e.g., C₆₀, C₇₀, C₈₀, or C₈₄), gold (Au₃), bismuth (Bi₃), and xenon (Xe₄₀) and other clusters are useful for deposition or etching. The term "cluster" includes not only groups of multiple fullerenes, but also single fullerene molecules which are considered as clusters of carbon atoms. Because each cluster has only one or a few unbalanced electric charges, the charge-to-mass ratio of the clusters can be significantly less than the charge-to-mass ratio of individual atoms or molecules used in charged-particle beams. Although the energy of the entire cluster can be relatively large, for example, several hundred to several thousand electron volts, the energy per component is low.

A typical protective layer is preferably between 0.05 µm and 1 µm thick, more preferably between 0.1 µm and 0.8 µm thick, and most preferably about 0.2 µm thick. A preferred protective layer is sufficiently conductive to dissipate any electrical charge produced by the impact of the charged-particle beam onto the work piece. A preferred protective layer is "vacuum friendly," that is, it does not "outgas" or continue to evaporate in a vacuum chamber to interfere with the charged-particle beam or contaminate the work piece. A preferred protective layer stabilizes the structures on the work piece. The preferred protective layer does not interact with or alter the structures on the work piece and provides mechanical strength so that the dimensions of structures change little or not at all under the impact of the charged-particle beam. The deposition is limited to areas near the impact point of the cluster beam.

Because the clusters have masses that are greater than that of the gallium ions in a typical prior art method, damage to the work piece is confined to surface layer that is thinner than the damage layer caused by a beam of gallium ions. Depending on composition, morphology, and size of clusters used, and the accelerating voltage, damage to the substrate can be confined within the top 20 nm, the top 10 nm, the top 5 nm or the top 2 nm. For example, using a 15 kV accelerating voltage for (singly charged) clusters of C₆₀, Au₃, or Bi₃ would typically limit damage to the top 5 nm of the work piece. By comparison, a typical gallium ion beam damages the surface to a depth of about 30 nm to 50 nm. The preferred accelerating voltage can vary with the type of clusters and the material of the work piece.

In some embodiments, the protective layer can be composed of the material from the clusters, such as a carbon layer deposited from fullerenes, and in such embodiments a deposition precursor gas is unnecessary. That is, the clusters directly deposit onto the work piece. In other embodiments, the protective layer is composed of decomposition products from the precursor gas. In other embodiments, a combination of the material in the cluster beam and decomposition products of a precursor gas is deposited.

In step 218, the region of interest, protected by the protection layer, is processed by a charged particle beam. For example, the region of interest can be viewed using scanning electron microscopy, or the region can be etched, or an additional material can be deposited using an ion beam. If a multi-source system is used as the source of the cluster beam, the plasma material that was the source of the clusters can be removed from the plasma chamber, and the plasma chamber can be filled with a different gas for performing a material removal process or a material deposition process, with or without an etch-enhancing gas or a precursor gas being directed to the region of interest. An example of a multi-source system is described in U.S. Prov. Pat. App. 60/830,978 filed July 14, 2006 for "A Multi-Source Plasma Focused Ion Beam System," which is assigned to the assignee of the present invention.

In other embodiments, an etch-enhancing gas can be used, and the beam of clusters provides energy to initiate a chemical reaction to etch the work piece with reduced damage outside of the etched area. Etch enhancing gases include XeF2, F2, Cl2, Br2, I2, fluorocarbons, such as trifluoro acetamide and trifluoroacetic acid and trichloroacetic acid, water, ammonia, and oxygen.

A preferred implementation of the invention uses a plasma source as described in U.S. Pat. App. Pub. No. 2005/0183667 for a "Magnetically Enhanced, Inductively Coupled Plasma Source for a Focused Ion Beam System". Such an ion source provides a beam having very low chromatic aberration and can be focused to a relatively small spot at a relatively high beam current, making it suitable for precise micromachining and deposition. Such a source can provide beams of clusters, as well as beams of individual atoms and molecules for charged particle beam processing. For example, a cluster beam can be used to deposit a protective layer, and then an argon beam can be used with xenon difluoride to micro-machine a feature in the work piece.

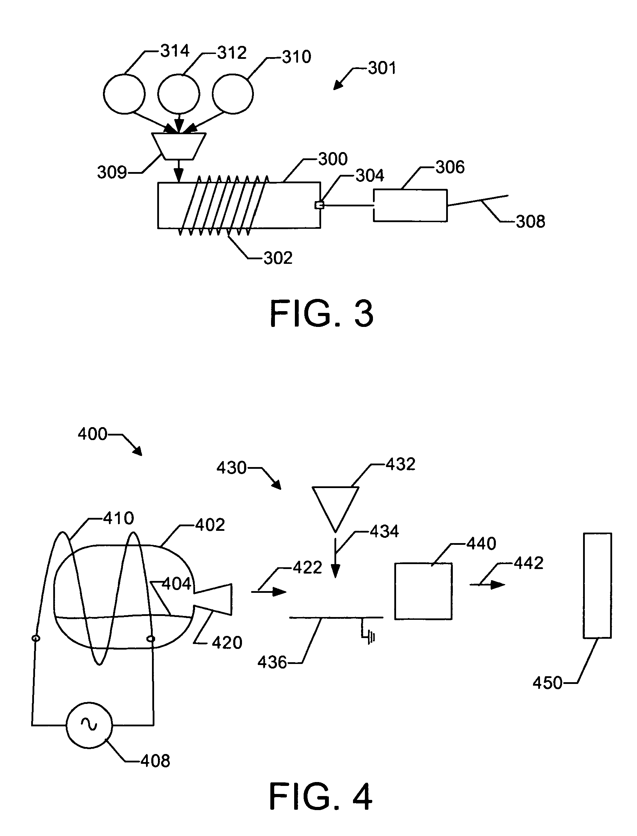

FIG. 3 shows a simplified schematic diagram of a preferred RF excited, plasma ion source 301. A ceramic plasma ion chamber 300 is wrapped by a coil 302. The coil is excited by an RF source(not shown). Ceramic plasma ion chamber 300 is a cylinder with aperture electrodes 304 at one end. The aperture electrodes exhibit an aperture centered on the cylinder axis of ceramic plasma ion chamber 300. An ion beam leaves ceramic plasma ion chamber 300 through the aperture of the electrodes 304 and passes through an ion beam focusing column 306 to produce a deflectable focused ion beam 308.

Ceramic plasma ion chamber 300 receives, through a valve 309, gas from one or more of a plurality of sources 310, 312, 314. Sources may comprise cluster gases, such as those described above, inert gases such as xenon (Xe) or helium (He), reactive gases such as oxygen (O₂), or precursor or etch-enhancing gases as described above. Valve 309 may be provided to select in sequence each of a plurality of different gases from the sources. Thus, one may choose one ion species for milling or etching and choose a second different ion species for deposition.

The source is convenient in that one material can be provided to the plasma source to produce a beam of clusters to provide a protective layer, and then a second material can be provided to the plasma source for further processing of the work piece. For example, one may introduce a gas containing C₆₀ to decompose a precursor gas to deposit a protective layer, and then introduce a gas such as Xe for sputtering.

FIG. 4 shows a schematic of an alternative embodiment of a cluster source 400. The cluster source 400 can be in its own vacuum chamber, or can be in a vacuum chamber that includes one or more additional charged particle beam columns, such as focused ion beam columns, e.g., liquid metal or plasma source columns, or electron beam columns. The non-cluster sources can be used, for example, to process a work piece after a protective layer is applied using the cluster source. The vacuum chamber can include a gas injection system to direct a deposition precursor gas or an etch-enhancing gas toward the work piece.

Cluster source 400 includes a crucible 402 containing a source material 404. A power source 408 heats a heating coil 410 to provide energy to evaporate source material 404. Evaporated atoms or molecules of source material 404, referred to generally as components, expand through a nozzle 420, which causes the atoms or molecules to condense into clusters 422. Clusters are preferably loosely bound groups of atoms or molecules. The components preferably do not form a crystalline structure in the clusters, but are amorphous, resembling a liquid state. Components can also be evaporated by a laser or a beam of electrons or ions.

The clusters 422 are charged in an ionizer 430, which may, for example, include an electron source 432 having an electrical potential to accelerate electrons 434 toward an electrode 436. The electrons 434 collide with clusters 422, ionizing some of the components. Typically only a small number of components, such as one or two, are ionized, so that the electrical charge on each cluster is small. The clusters are optionally passed though a mass filter 440, which may use a combination of electrostatic fields, magnetic fields, and apertures so that a beam of cluster 442 having masses in a desired range exit the mass filter 440 and are directed toward the work piece 450. Skilled persons will recognize that the cluster source described in FIG. 4 is simplified, and that many variations and improvements are known and used.

Such cluster sources have been used, for example, to provide coating for optical components. A typical cluster from the source of FIG. 4 includes between 2 and 10,000 atoms or molecules. The components of a cluster may be loosely bound to each other, although components in some clusters, such as the carbon atoms in fullerenes, are more strongly bound. An efficient cluster source produces a relatively large number of clusters of the desired size, compared to the number of unattached components or clusters of undesirable sizes that are produced. Clusters are charged and typically directed toward the target by electrostatic forces. Because the components can be loosely bound in the cluster, the energy of the cluster can cause it to disintegrate upon impact and allow the components to spread out into a relatively thin, uniform layer on the surface.

Cluster ion sources, including those using C₆₀, have been used in secondary mass ion spectroscopy to eject material from the surface of a work piece. The low energy per component insures that little momentum is transferred to individual atoms and molecules in the work piece, resulting in very little mixing of the work piece material.

It is noted that the term charged-particle-beam "processing" as used herein includes imaging, as well as sputtering, etching and depositing.

## Claims

1. A method for processing a work piece (112) with a beam of charged particles, the method comprising:
• positioning the work piece in a vacuum chamber (114);
• irradiating the work piece surface with a focused beam of charged clusters of atoms or molecules (108); and
• directing to the work piece a gas;
• **characterized in that**
• the focused beam of clusters initiates a chemical reaction in which the gas decomposes to deposit a material onto the work piece or the gas is activated to etch the work piece to remove a material from the work piece.

2. The method according to claim 1 in which the charged clusters comprise carbon, gold, bismuth or xenon.

3. The method according to claim 2 in which the beam of charged clusters comprises clusters comprising C₆₀, C₇₀, C₈₀, C₈₄, Au₃, Bi₃ or Xe₄₀.

4. The method according to any of the above claims in which the beam of charged clusters comprises fullerenes.

5. The method according to any of the above claims in which the gas reacts in the presence of the focused beam of charged clusters to etch the work piece.

6. The method according to claim 5 in which the gas comprises XeF₂, F₂, Cl₂, Br₂, I₂, a fluorocarbon, trifluoro acetamide, trifluoroacetic acid, trichloroacetic acid, water, ammonia, or oxygen.

7. The method according to any of claims 1-4 in which the gas comprises a precursor gas comprising a silane compound or an organometallic compound, the precursor gas decomposing in the presence of the beam of charged clusters, the decomposed gas thereby forming a deposited layer on the work piece (112).

8. The method according to claim 7 in which the gas comprises tetramethylorthosilane (TMOS), tetraethylorthosilane (TEOS), tetrabutoxysilane (Si(OC₄ H₉)), dimethyl acetylacetonate gold, tungsten hexacarbonyl (W(CO)₆), or methylcyclopentadienyl trimethyl platinum (C₉H₁₆Pt).

9. The method according to any of claims 1-4, 7 or 8 in which the work piece is irradiated with a beam of charged clusters so as to form a deposited layer, and the thus formed deposited layer is further processed by being irradiated with a further beam of charged particles.

10. The method according to claim 9 in which the further beam of charged particles (107) is a focused beam of single atom ions or electrons.

11. The method according to claim 10 in which the deposited layer forms a protective layer to protect the work piece surface during processing by the focused beam of ions or electrons.

12. The method according to any of the preceding claims in which directing a beam of charged clusters to the work piece includes directing a beam of charged clusters from a plasma ion source (301) to the work piece.

13. The method of claim 12 in which the plasma ion source (301) is an inductively coupled plasma ion source.

14. The method according to any of claims 1-11 in which directing a beam of charged clusters to the work piece includes directing a beam of charged clusters from an evaporative cluster source (400) to the work piece.

15. The method according to any of claims 1-4 or 7-14 in which the deposited layer comprises material of which the charged clusters are formed.

16. The method according to any of the preceding claims in which the clusters forming the beam of charged clusters have a charge-per-atom ratio of less than 0.1.

17. The method of claim 16 in which the charge-per atom-ratio is less than 0.01.

18. The method according to any of claims 1 or 6-14 in which the beam of charged clusters comprises clusters of inert gases.

19. A charged particle apparatus for processing a work piece (112), the apparatus comprising:
• a vacuum chamber (114);
• a work piece support (116) for supporting the work piece within said vacuum chamber in a work piece position (110);
• a charged particle source for producing a beam of charged clusters;
• at least one focusing lens for focusing said beam of charged clusters on the work piece position; and
• a gas injection system (104) for directing a gas toward the work piece position **characterized in that**
• the focused beam of charged clusters is arranged to intiate a chemical reaction in which the gas decomposes to deposit a material onto the work piece or the gas is activated to etch the work piece to remove a material from the work piece.

20. The apparatus according to claim 19 in which the source of a beam of charged particles comprises a plasma ion source (301).

21. The apparatus according to claim 20 in which the plasma ion source is an inductively coupled plasma ion source.

22. The apparatus according to any of claims 19-21 in which the source of a beam of charged particles comprises an evaporative cluster ion source (400).

23. The apparatus according to any of claims 19-22 in which the charged clusters are produced by a cluster ion source (301, 400), the cluster ion source equipped to produce clusters comprising fullerenes, bismuth, gold, or xenon.

## Patentansprüche

1. Verfahren zum Bearbeiten eines Werkstücks (112) mit einem Ladungsträgerstrahl, wobei das Verfahren aufweist:
- Positionieren des Werkstücks in einer Vakuumkammer (114);
- Bestrahlen der Werkstückoberfläche mit einem fokussierten Strahl von geladenen Atom- oder Molekülclustern (108); und
- Lenken eines Gases auf das Werkstück;
**dadurch gekennzeichnet, dass**
- der fokussierte Clusterstrahl eine chemische Reaktion auslöst, bei der sich das Gas zersetzt, um ein Material auf dem Werkstück abzuscheiden, oder das Gas aktiviert wird, um das Werkstück zu ätzen und ein Material von der Werkstückoberfläche abzutragen.

2. Verfahren nach Anspruch 1, wobei die geladenen Cluster Kohlenstoff, Gold, Bismuth oder Xenon aufweisen.

3. Verfahren nach Anspruch 2, wobei der Strahl von geladenen Clustern Cluster aufweist, die C₆₀, C₇₀, C₈₀, C₈₄, Au₃, Bi₃ oder Xe₄₀ aufweisen.

4. Verfahren nach einem der vorstehenden Ansprüche, wobei der Strahl von geladenen Clustern Fullerene aufweist.

5. Verfahren nach einem der vorstehenden Ansprüche, wobei das Gas in Anwesenheit des fokussierten Strahls von geladenen Clustern reagiert und das Werkstück ätzt.

6. Verfahren nach Anspruch 5, wobei das Gas XeF₂, F₂, Cl₂, Br₂, I₂, einen Fluorkohlenstoff, Trifluoracetamid, Trifluoressigsäure, Trichloressigsäure, Wasser, Ammoniak oder Sauerstoff aufweist.

7. Verfahren nach einem der Ansprüche 1-4, wobei das Gas ein Vorläufergas mit einer Silanverbindung oder einer metallorganischen Verbindung aufweist, wobei sich das Vorläufergas in Anwesenheit des Strahls von geladenen Clustern zersetzt und das zersetzte Gas dadurch eine auf dem Werkstück (112) abgeschiedene Schicht bildet.

8. Verfahren nach Anspruch 7, wobei das Gas Tetramethylorthosilan (TMOS), Tetraethylorthosilan (TEOS), Tetrabutoxysilan (Si(OC₄H₉)), Dimethylacetylacetonat-Gold, Wolframhexacarbonyl (W(CO)₆) oder Methylcyclopentadienyltrimethylplatin (C₉H₁₆Pt) aufweist.

9. Verfahren nach einem der Ansprüche 1-4, 7 oder 8, wobei das Werkstück mit einem Strahl von geladenen Clustern bestrahlt wird, um eine abgeschiedene Schicht zu bilden, und die so gebildete abgeschiedene Schicht weiter bearbeitet wird, indem sie mit einem weiteren Strahl von geladenen Teilchen (Ladungsträgerstrahl) bestrahlt wird.

10. Verfahren nach Anspruch 9, wobei der weitere Ladungsträgerstrahl (107) ein fokussierter Strahl aus einzelnen Atomionen oder Elektronen ist.

11. Verfahren nach Anspruch 10, wobei die abgeschiedene Schicht eine Schutzschicht bildet, um die Werkstückoberfläche während der Bearbeitung durch den fokussierten Ionen- oder Elektronenstrahl zu schützen.

12. Verfahren nach einem der vorstehenden Ansprüche, wobei das Richten eines Strahls von geladenen Clustern auf das Werkstück das Richten eines Strahls von geladenen Clustern aus einer Plasmaionenquelle (301) auf das Werkstück beinhaltet.

13. Verfahren nach Anspruch 12, wobei die Plasmaionenquelle (301) eine induktiv gekoppelte Plasmaionenquelle ist.

14. Verfahren nach einem der Ansprüche 1-11, wobei das Richten des Strahls von geladenen Clustern auf das Werkstück das Richten eines Strahls von geladenen Clustern aus einer Verdampfungs-Clusterquelle (400) auf das Werkstück beinhaltet.

15. Verfahren nach einem der Ansprüche 1-4 oder 7-14, wobei die abgeschiedene Schicht Material aufweist, aus dem die geladenen Cluster gebildet werden.

16. Verfahren nach einem der vorstehenden Ansprüche, wobei die Cluster, die den Strahl von geladenen Clustern bilden, ein Ladung-pro-Atom-Verhältnis von weniger als 0,1 aufweisen.

17. Verfahren nach Anspruch 16, wobei das Ladung-pro-Atom-Verhältnis kleiner als 0,01 ist.

18. Verfahren nach einem der Ansprüche 1 oder 6-14, wobei der Strahl von geladenen Clustern Cluster von Inertgasen aufweist.

19. Ladungsträger-Vorrichtung zur Bearbeitung eines Werkstücks (112), wobei die Vorrichtung aufweist:
- eine Vakuumkammer (114);
- einen Werkstückträger (116) zum Unterstützen des Werkstücks innerhalb der Vakuumkammer in einer Werkstückposition (110);
- eine Ladungsträgerquelle zum Erzeugen eines Strahls von geladenen Clustern;
- mindestens eine Sammellinse zum Fokussieren des Strahls von geladenen Clustern auf die Werkstückposition; und
- ein Gasinjektionssystem (104) zum Lenken eines Gases zur Werkstückposition;
**dadurch gekennzeichnet, dass**
der fokussierte Strahl von geladenen Clustern so eingerichtet ist, dass er eine chemische Reaktion auslöst, in der sich das Gas zersetzt, um ein Material auf das Werkstück abzuscheiden, oder das Gas aktiviert wird, um das Werkstück zu ätzen und ein Material von dem Werkstück abzutragen.

20. Vorrichtung nach Anspruch 19, wobei die Quelle eines Ladungsträgerstrahls eine Plasmaionenquelle (301) aufweist.

21. Vorrichtung nach Anspruch 20, wobei die Plasmaionenquelle eine induktiv gekoppelte Plasmaionenquelle ist.

22. Vorrichtung nach einem der Ansprüche 19-21, wobei die Quelle eines Ladungsträgerstrahls eine Verdampfungs-Clusterionenquelle (400) aufweist.

23. Vorrichtung nach einem der Ansprüche 19-22, wobei die geladenen Cluster durch eine Clusterionenquelle (301, 400) erzeugt werden, wobei die Clusterionenquelle so ausgestattet ist, dass sie Cluster produziert, die Fullerene, Bismuth, Gold oder Xenon aufweisen.

## Revendications

1. Procédé pour la transformation d'une pièce à usiner (112) avec un faisceau de particules chargées, le procédé comprenant :
. le positionnement de la pièce à usiner dans une chambre sous vide (114) ;
. l'irradiation de la surface de la pièce à usiner avec un faisceau focalisé d'amas chargés d'atomes ou de molécules (108) ; et
. la direction d'un gaz vers la pièce à usiner ;
. **caractérisé en ce que**
. le faisceau focalisé d'amas initie une réaction chimique dans laquelle le gaz se décompose pour déposer un matériau sur la pièce à usiner ou le gaz est activé pour décaper la pièce à usiner afin d'éliminer un matériau de la pièce à usiner.

2. Procédé selon la revendication 1, dans lequel les amas chargés comprennent du carbone, de l'or, du bismuth ou du xénon.

3. Procédé selon la revendication 2, dans lequel le faisceau d'amas chargés comprend des amas comprenant C₆₀, C₇₀, C₈₀, C₈₄, Au₃, Bi₃ ou Xe₄₀.

4. Procédé selon l'une quelconque des revendications ci-dessus, dans lequel le faisceau d'amas chargés comprend des fullerènes.

5. Procédé selon l'une quelconque des revendications ci-dessus, dans lequel le gaz réagit en présence du faisceau focalisé d'amas chargés pour décaper la pièce à usiner.

6. Procédé selon la revendication 5, dans lequel le gaz comprend XeF₂, F₂, Cl₂, Br₂, I₂, un fluorocarbone, le trifluoroacétamide, l'acide trifluoroacétique, l'acide trichloroacétique, l'eau, l'ammoniac ou l'oxygène.

7. Procédé selon l'une quelconque des revendications 1-4, dans lequel le gaz comprend un gaz précurseur comprenant un composé de silane ou un composé organométallique, le gaz précurseur se décomposant en présence du faisceau d'amas chargés, le gaz décomposé formant par-là une couche de dépôt sur la pièce à usiner (112).

8. Procédé selon la revendication 7, dans lequel le gaz comprend du tétraméthylorthosilane (TMOS), du tétraéthylorthosilane (TEOS), du tétrabutoxysilane (Si(OC₄H₉)), du diméthylacétylacétonate or, du tungstène hexacarbonyle (W(CO)₆), ou du méthylcyclopentadiényltriméthylplatine (C₉H₁₆Pt).

9. Procédé selon l'une quelconque des revendications 1-4, 7 ou 8 dans lequel la pièce à usiner est irradiée avec un faisceau d'amas chargés afin de former une couche de dépôt, et la couche de dépôt ainsi formée est de plus traitée en étant irradiée avec un autre faisceau de particules chargées.

10. Procédé selon la revendication 9, dans lequel l'autre faisceau de particules chargées (107) est un faisceau focalisé d'ions d'un seul atome ou d'électrons.

11. Procédé selon la revendication 10, dans lequel la couche de dépôt forme une couche protectrice pour protéger la surface de la pièce à usiner pendant un traitement par le faisceau focalisé d'ions ou d'électrons.

12. Procédé selon l'une quelconque des revendications précédentes, dans lequel la direction d'un faisceau d'amas chargés vers la pièce à usiner comprend la direction d'un faisceau d'amas chargés à partir d'une source d'ions de plasma (301) vers la pièce à usiner.

13. Procédé selon la revendication 12, dans lequel la source d'ions de plasma (301) est une source d'ions de plasma couplée par induction.

14. Procédé selon l'une quelconque des revendications 1-11, dans lequel la direction d'un faisceau d'amas chargés vers la pièce à usiner comprend la direction d'un faisceau d'amas chargés à partir d'une source d'amas en évaporation (400) vers la pièce à usiner.

15. Procédé selon l'une quelconque des revendications 1-4 ou 7-14, dans lequel la couche de dépôt comprend un matériau duquel les amas chargés sont formés.

16. Procédé selon l'une quelconque des revendications précédentes, dans lequel les amas formant le faisceau d'amas chargés présentent un rapport charge-par-atome inférieur à 0,1.

17. Procédé selon la revendication 16, dans lequel le rapport charge-par-atome est inférieur à 0,01.

18. Procédé selon l'une quelconque des revendications 1 ou 6-14, dans lequel le faisceau d'amas chargés comprend des amas de gaz inertes.

19. Appareil de particules chargées pour le traitement d'une pièce à usiner (112), l'appareil comprenant :
. une chambre sous vide (114) ;
. un support de pièces à usiner (116) pour supporter la pièce à usiner à l'intérieur de ladite chambre sous vide dans une position de pièce à usiner (110) ;
. une source de particules chargées pour produire un faisceau d'amas chargés ;
. au moins une lentille de focalisation pour focaliser ledit faisceau d'amas chargés sur la position de la pièce à usiner ; et
. un système d'injection de gaz (104) pour diriger un gaz vers la position de la pièce à usiner
**caractérisé en ce que**
. le faisceau focalisé d'amas chargés est disposé pour initier une réaction chimique dans laquelle le gaz se décompose pour déposer un matériau sur la pièce à usiner ou le gaz est activé pour décaper la pièce à usiner afin d'éliminer un matériau de la pièce à usiner.

20. Appareil selon la revendication 19, dans lequel la source d'un faisceau de particules chargées comprend une source d'ions de plasma (301).

21. Appareil selon la revendication 20, dans lequel la source d'ions de plasma est une source d'ions de plasma couplée par induction.

22. Appareil selon l'une quelconque des revendications 19-21, dans lequel la source d'un faisceau de particules chargées comprend une source d'ions d'amas en évaporation (400).

23. Appareil selon l'une quelconque des revendications 19-22, dans lequel les amas chargés sont produits par une source d'ions d'amas (301, 400), la source d'ions d'amas est équipée pour produire des amas comprenant des fullerènes, du bismuth, de l'or, ou du xénon.
